# EUROPEAN PATENT SPECIFICATION

(11) **EP 3 238 278 B1**
(45) Date of publication and mention of the grant of the patent: **04.03.2020**
(21) Application number: 15874148.8
(22) Date of filing: 16.12.2015
(51) Int. Cl.: H01L 33/62, F21V 29/70, F21L 4/02, F21Y 115/10

(54) **IMPROVED EFFICIENCY LIGHTING APPARATUS WITH LED DIRECTLY MOUNTED TO A HEATSINK**
EFFIZIENTERE BELEUCHTUNGSVORRICHTUNG MIT DIREKT AN EINEM KÜHLKÖRPER BEFESTIGTER LED
APPAREIL D'ÉCLAIRAGE À EFFICACITÉ AMÉLIORÉE POURVU D'UNE DEL MONTÉE DIRECTEMENT SUR UN DISSIPATEUR THERMIQUE

(30) Priority: 22.12.2014 US 201462095733 P
(43) Date of publication of application: 01.11.2017
(73) Proprietor: MAG Instrument, Inc., Ontario, CA 91761 (US)
(72) Inventor: MAGLICA, Anthony, Ontario, CA 91761 (US)
(74) Representative: Jakelski & Althoff Patentanwälte PartG mbB
(86) International application number: PCT/US2015/066201
(87) International publication number: WO 2016/106053

(56) References cited:
- WO-A1-2014/037621
- US-A1- 2005 017 366
- US-A1- 2007 109 775
- US-A1- 2007 117 273
- US-A1- 2010 314 986
- US-A1- 2014 218 902
- US-A1- 2014 347 846
- US-B2- 8 733 966

## Description

### Background

LED efficiency and light output drops as the device heats up during operation. Typically, LEDs are mounted on laminated printed circuit boards. Some are mounted on special metal back or ceramic printed circuit boards in an attempt to conduct heat away from the LED.

US 2010/0314986 A1 discloses methods and devices for an improved light source. In one exemplary embodiment a light source includes a heat sink, a LED die, and a phosphor dome. A conductive material can be disposed in the heat sink, the LED die can be mounted to a top portion of the conductive material such that the LED die is in electrical contact with the heat sink, and the phosphor dome can be coupled to a top face of the heatsink. In another embodiment, a light source includes a heat sink, a sleeve, a LED package, and an optic. A conductive material can be disposed in the heat sink, the sleeve can be disposed around at least a portion of the heat sink and the conductive material, the LED package can be mounted above the conductive material and the optic can be located above the LED package and coupled to the sleeve. The light sources disclosed in US 2010/0314986 A1 can be used to prepare existing miniature bulbs in a number of different devices, including medical devices such as otoscopes.

WO 2014/031621 A1 discloses a method for manufacturing LED lighting devices and LED lighting devices, wherein connecting means of metallic solderable material to be electrically connected to the anode and cathode of a LED diode component are provided. The connecting means are at least partly embedded into a plastic material, to provide an electrical connection for said LED diode component and a heat sink for its thermal dissipation.

From US 2005/0017366 A1 a LED lighting assembly with improved heat management is known.

US 2007/0109775 A1 discloses flashlights utilizing unique LED light sources.

### SUMMARY OF THE INVENTION

The invention is generally directed to a lighting apparatus according to claim 1, in which at least one LED is mounted to the top surface of a heat sink held within an outer casing that is thermally and electrically conductive, the LED having a first conductive member which is thermally and electrically directly connected to the heatsink without the use of a printed circuit board and a second electrically conductive member which is electrically isolated from the heatsink by an electrical insulating material held within the heatsink.

The second electrically conductive member of the LED can be soldered to a terminal held within the electrical insulating material while the first electrically conductive member of the LED can also be soldered to the heat sink and the resulting heat sink assembly can be press fit into a tube or barrel (such as an aluminum flashlight barrel) or inserted into the tube or barrel and then removably retained by a mechanical means such as a nut threaded to the tube or barrel. Alternatively, the heatsink can be integrally formed with the tube or barrel.

Accordingly, it is a primary object of the present invention to provide a lighting apparatus having improved efficiency by directly mounting an LED to a heatsink.

This and further objects and advantages will be apparent to those skilled in the art in connection with the drawings and the detailed description of the invention set forth below.

### BRIEF DESCRIPTION OF THE DRAWINGS

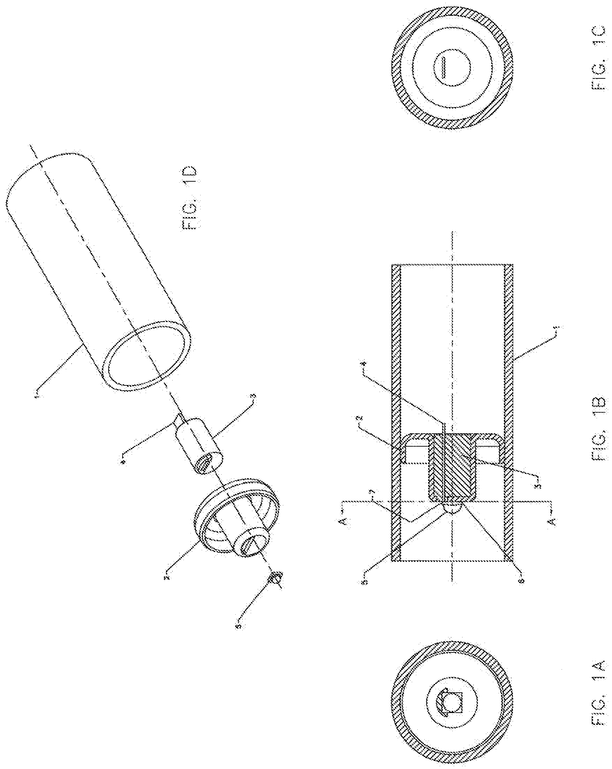

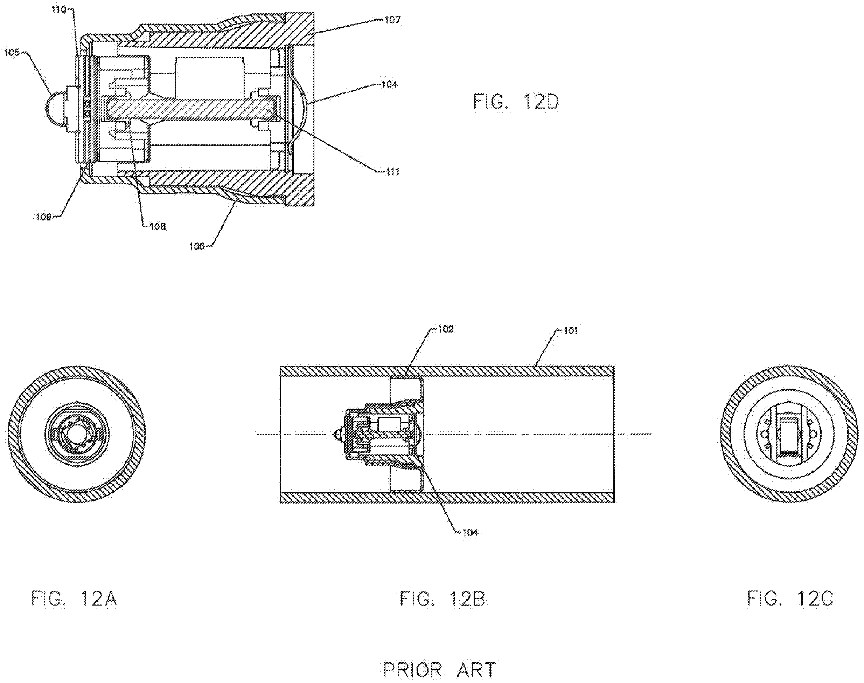

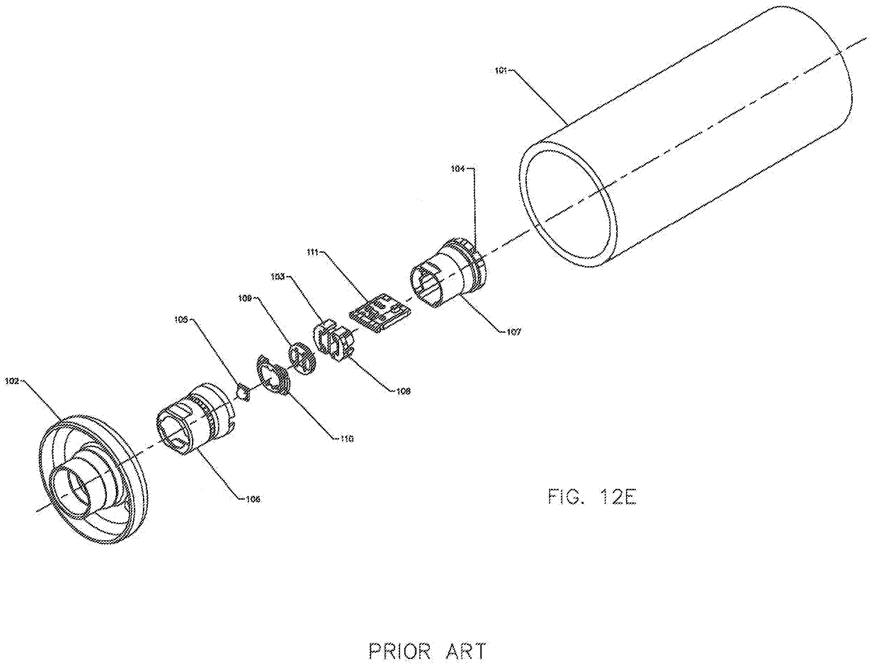

The drawings will hereinafter be described by a brief reference to the drawings and then a description of the numerical elements identified in the drawing.
**Figs. 1A-D** show a heatsink and insulating core installed in a metal tube or flashlight barrel having the following identified elements:
   1. Tube or barrel
   2. Heatsink
   3. Insulator
   4. Terminal to connect power to LED
   5. LED
   6. Thermal junction and first electrical connection between LED and heatsink
   7. Second electrical connection
   Fig. 1B is a cross sectional view which is shown exploded in Fig. 1D while Figs. 1A and 1C are, respectively, top and bottom views looking into the apparatus shown in cross section in Fig. 1B.
**Figs. 2A-D** show a variation on Figs. 1A-D in which the heatsink and insulating core are installed in a metal tube or flashlight barrel having the following identified elements:
   1. Tube or barrel
   2. Heatsink
   3. Insulator
   4. Terminal to connect power to LED
   5. LED
   6. Thermal junction and first electrical connection between LED and heatsink
   7. Second electrical connection
   Fig. 2B is a cross sectional view which is shown exploded in Fig. 2D while Figs. 2A and 2C are, respectively, top and bottom views looking into the apparatus shown in cross section in Fig. 2B.
**Figs. 3A-D** show a one-piece heatsink similar to that shown in Figs. 2A-D having the following identified elements:
   1. Integral tube or barrel and heatsink
   3. Insulator
   4. Terminal to connect power to LED
   5. LED
   6. Thermal junction and first electrical connection between LED and heatsink
   7. Second electrical connection
   Fig. 3B is a cross sectional view which is shown exploded in Fig. 3D while Figs. 3A and 3C are, respectively, top and bottom views looking into the apparatus shown in cross section in Fig. 3B.
**Figs. 4A-D** show a variation on the heatsink and insulating core in Figs. 1A-D. In this example, there is a printed circuit board between the LED and the other end of the assembly having the following identified elements:
   1. Tube or barrel
   2. Heatsink
   3. Insulator
   4. Terminal to connect power to LED
   5. LED
   6. Thermal junction and first electrical connection between LED and heatsink
   7. Second electrical connection
   8. Printed circuit board
   9. Insulator
   10. Contact
   Fig. 4B is a cross sectional view which is shown exploded in Fig. 4D while Figs. 4A and 4C are, respectively, top and bottom views looking into the apparatus shown in cross section in Fig. 4B.
**Figs. 5A-D** show a variation of the assembly shown in Figs. 4A-D having the following identified elements:
   1. Tube or barrel
   2. Heatsink
   3. Insulator
   4. Terminal to connect power to LED
   5. LED
   6. Thermal junction and first electrical connection between LED and heatsink
   7. Second electrical connection
   8. Printed circuit board
   9. Insulator
   10. Contact
   Fig. 5B is a cross sectional view which is shown exploded in Fig. 5D while Figs. 5A and 5C are, respectively, top and bottom views looking into the apparatus shown in cross section in Fig. 5B.
**Figs. 6A-D** show a heatsink similar to that in Figs. 3A-D but containing a printed circuit board having the following identified elements:
   1. Integral tube or barrel and heatsink
   3. Insulator
   4. Terminal to connect power to LED
   5. LED
   6. Thermal junction and first electrical connection between LED and heatsink
   7. Second electrical connection
   8. Printed circuit board
   9. Insulator
   10. Contact
   Fig. 6B is a cross sectional view which is shown exploded in Fig. 6D while Figs. 6A and 6C are, respectively, top and bottom views looking into the apparatus shown in cross section in Fig. 6B.
**Figs. 7A-D** show a circular array of LEDs mounted on a common heatsink. Four LEDs are shown here but there could be any number of LEDs. Figs. 7A-D have the following identified elements:
   1. Tube or barrel
   2. Heatsink
   3. Insulator
   4. Terminal to connect power to LED
   5. LED
   6. Thermal junction and first electrical connection between LED and heatsink
   7. Second electrical connection
   Fig. 7B is a cross sectional view which is shown exploded in Fig. 7D while Figs. 7A and 7C are, respectively, top and bottom views looking into the apparatus shown in cross section in Fig. 7B.
**Figs. 8A-D** show a circular array of LEDs mounted to a common heatsink with printed circuit boards in the insulating member. Four LEDs are shown here but there could be any number of LEDs. Figs. 8A-D have the following identified elements:
   1. Tube or barrel
   2. Heatsink
   3. Insulator
   4. Terminal to connect power to LED
   5. LED
   6. Thermal junction and first electrical connection between LED and heatsink
   7. Second electrical connection
   8. Printed circuit board
   9. Insulator
   10. Contact
   Fig. 8B is a cross sectional view which is shown exploded in Fig. 8D while Figs. 8A and 8C are, respectively, top and bottom views looking into the apparatus shown in cross section in Fig. 8B.
**Figs. 9A-C** show a linear array of LEDs on a common heatsink. Four LEDs are shown here but there could be any number of LEDs. Figs. 9A-C have the following identified elements:
   2. Heatsink
   3. Insulator
   4. Terminal to connect power to LED
   5. LED
   6. Thermal junction and first electrical connection between LED and heatsink
   7. Second electrical connection
   Fig. 9B is a cross sectional view of a single LED and Figs. 9A and 9C are, respectively, top and bottom views of a linear array of four LEDs.
**Figs. 10A-C** show a linear array of LEDs similar to those on Figs. 9A and 9C but containing printed circuit boards. Four LEDs are shown here but there could be any number of LEDs. Figs. 10A-C have the following identified elements:
   2. Heatsink
   3. Insulator
   4. Terminal to connect power to LED
   5. LED
   6. Thermal junction and first electrical connection between LED and heatsink
   7. Second electrical connection
   8. Printed circuit board
   9. Insulator
   10. Contact
   Fig. 10B is a cross sectional view of a single LED and Figs. 10A and 10C are, respectively, top and bottom views of a linear array of four LEDs.
Fig. 11 is a cross sectional magnified view from Fig. 1B which shows the top of heatsink 5 without the LED in place having the following identified elements:
   6. Thermal junction and first electrical connection between LED and heatsink
   7. Second electrical connection
**Figs. 12A-E** show a typical prior art LED assembly showing the LED soldered to a PC board and the multiple thermal junctions required to conduct heat to ambient air having the following identified elements:
   101. Tube or barrel
   102. Heatsink
   103. Insulator
   104. Contact for applying power to printed circuit board
   105. LED
   106. Housing
   107. Insulator
   108. Contact for connecting printed circuit board 111 to PCB 109
   109. Multilayered printed circuit board
   110. Ring Contact
   111. Printed circuit board
   Fig. 12B is a cross sectional view which is shown exploded in Fig. 12E while Figs. 12A and 12C are, respectively, top and bottom views looking into the apparatus shown in cross section in Fig. 12B and Fig. 12D is an enlarged cutaway view of Fig. 12B.

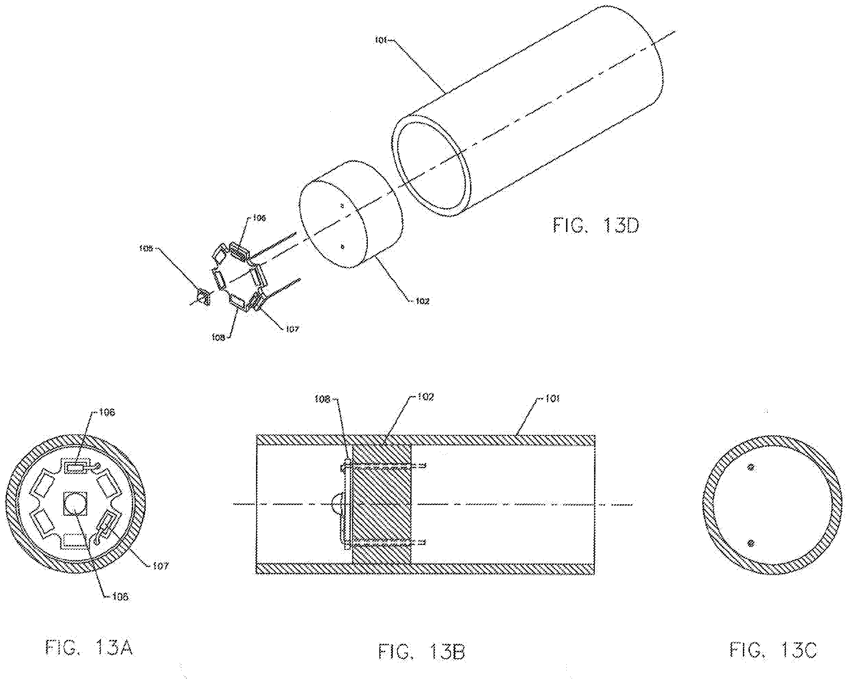

**Figs. 13A-D** show a widely used prior art star type, metal and ceramic backed PC board to which the LED is mounted and the multiple thermal junctions required to conduct heat to ambient air having the following identified elements:
   101. Tube or barrel
   102. Heatsink
   105. LED
   106. First power connection
   107. Second power connection
   108. Star PC board
   Fig. 13B is a cross sectional view which is shown exploded in Fig. 13D while Figs. 13A and 13C are, respectively, top and bottom views looking into the apparatus shown in cross section in Fig. 13B.

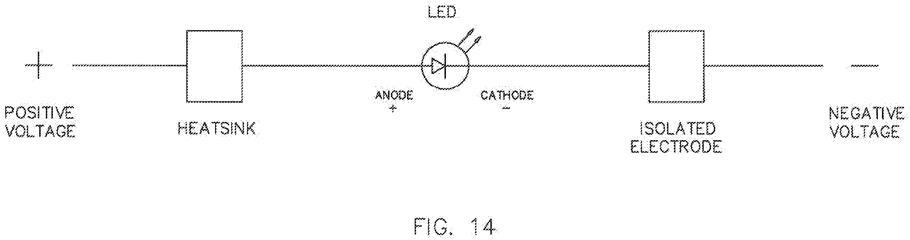

**Fig. 14** is a block diagram of a typical heatsink mounted LED with positive polarity heatsink.

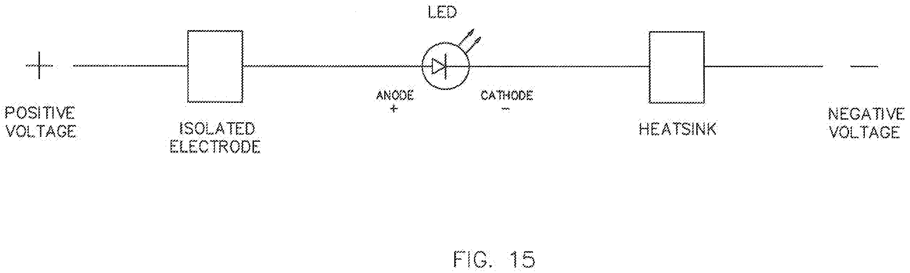

**Fig. 15** is a block diagram of a typical heatsink mounted LED with negative polarity heatsink.

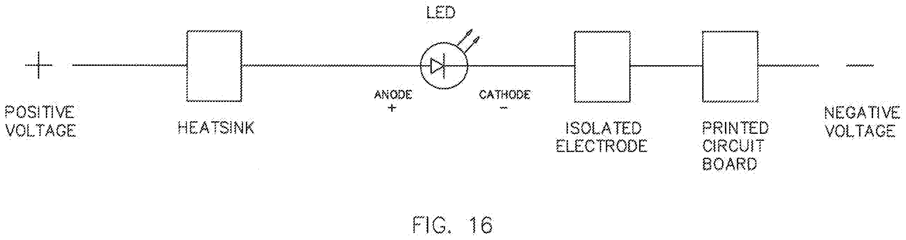

**Fig. 16** is a block diagram of a typical heatsink mounted LED with a positive polarity heatsink that incorporates a PC board with LED drive electronics.

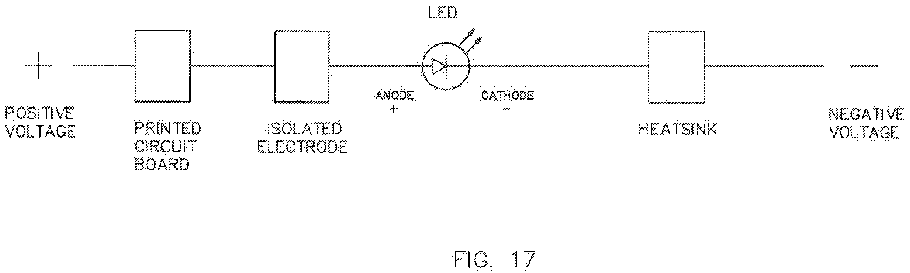

**Fig. 17** is a block diagram of a typical heatsink mounted LED with a negative polarity heatsink that incorporates a PC board with LED drive electronics.

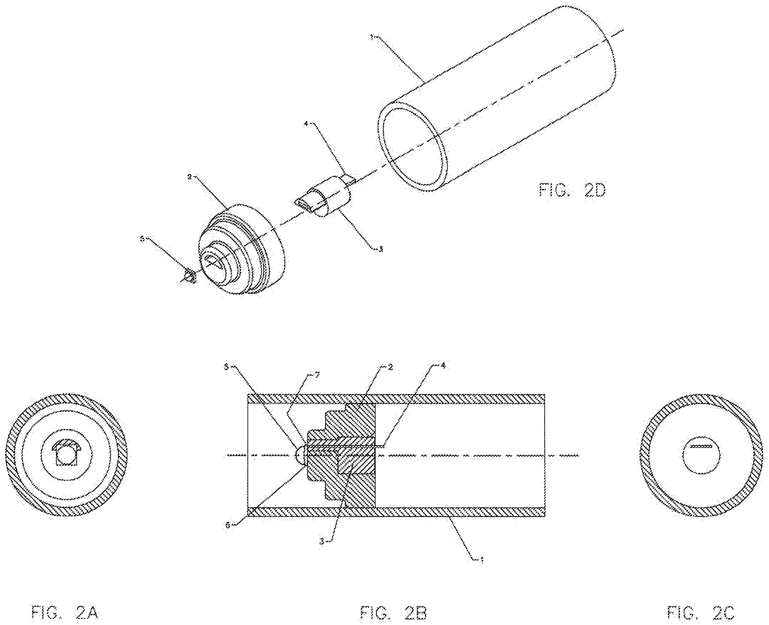

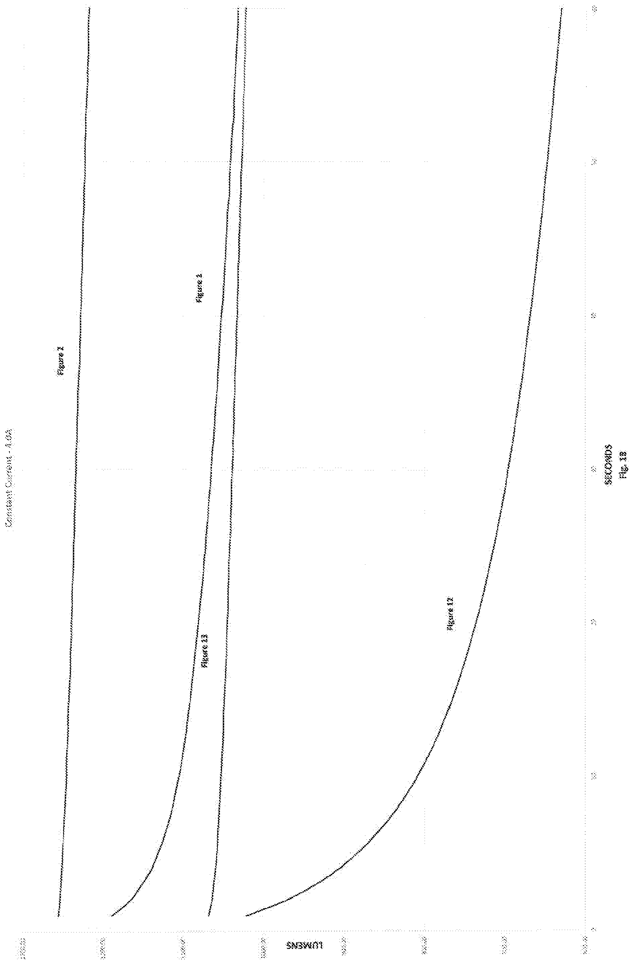

**Fig. 18** is a comparison of the performance of four different heatsinking methods or systems. Figure 2 curve is for the present invention and demonstrates superior performance with minimal drop off in lumens output over time.
   1. Curve labeled Figure 1 is a graphical representation of the lumens output over time showing the drop off in performance as the LED heats and efficiency drops for the system OF Figs. 1A-D.
   2. Curve labeled Figure 2 is a graphical representation of the lumens output over time showing very minimal drop off in performance as the LED heats and efficiency drops for the system of Figs. 2A-D.
   3. Curve labeled Figure 13 is a graphical representation of the lumens output over time showing the drop off in performance as the LED heats and efficiency drops for the system of Figs. 13A-D.
   4. Curve labeled Figure 12 is a graphical representation of the lumens output over time showing the drop off in performance as the LED heats and efficiency drops for the system of Figs. 12A-E.

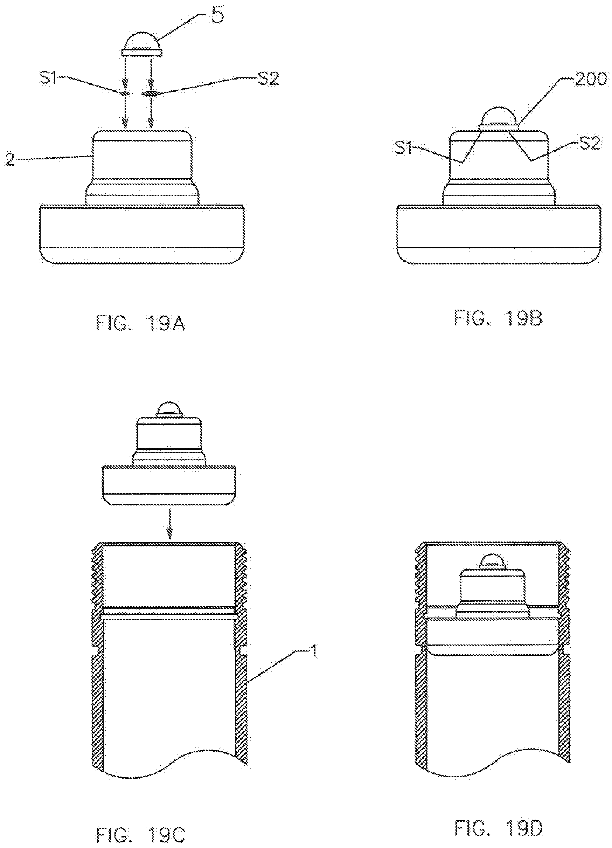

**Figs. 19A-B** illustrate a process for manufacturing a heat sink assembly in accordance with the present invention in which solder S1 and S2 is used to solder pads of an LED 5 to a top surface of a heat sink 2 to form a heat sink assembly 200. Figs. 19C-D illustrate a press fit step of inserting heat sink assembly 200 into a tube or barrel 1.

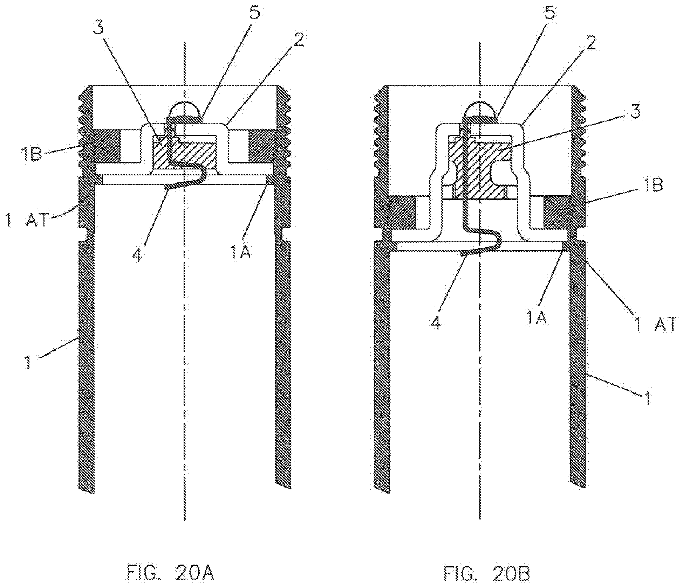

**Figs. 20A and 20B** show variations on Figs. 19C-D in which the heatsink and insulating core are installed in a metal tube or flashlight barrel having the following identified elements:
   1. Tube or barrel
   1A. Shoulder of tube or barrel 1
   1AT. Top surface of shoulder 1A
   1B. Nut
   2. Heatsink
   3. Insulator
   4. Terminal to connect power to LED
   5. LED

### DETAILED DESCRIPTION OF INVENTION

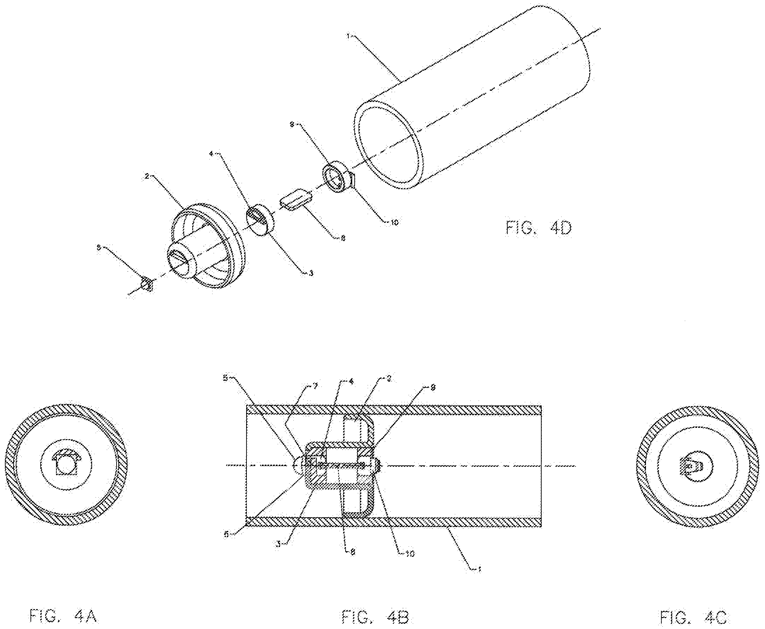

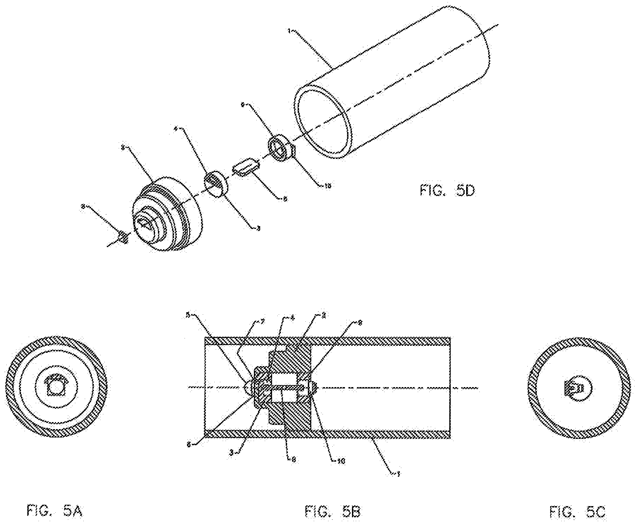

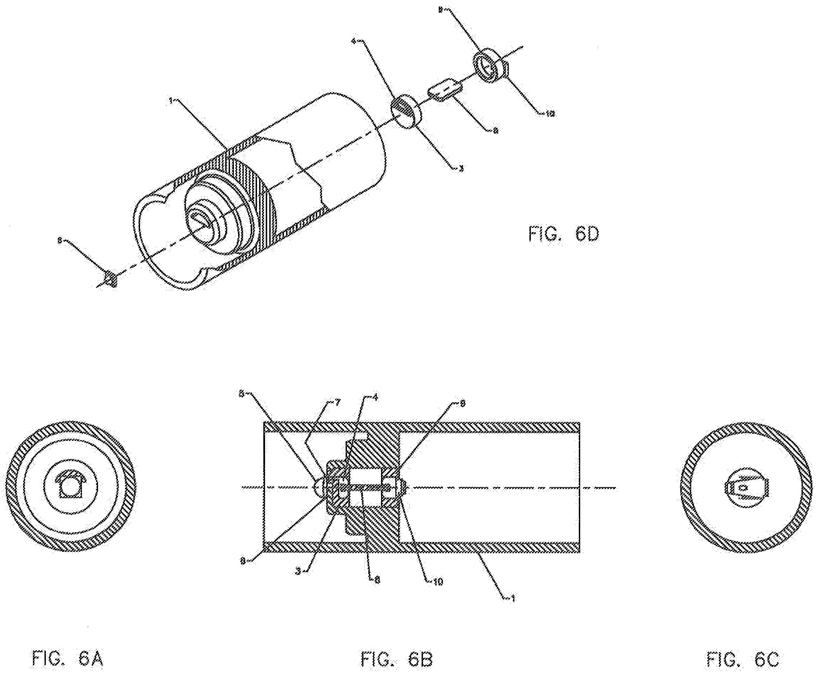

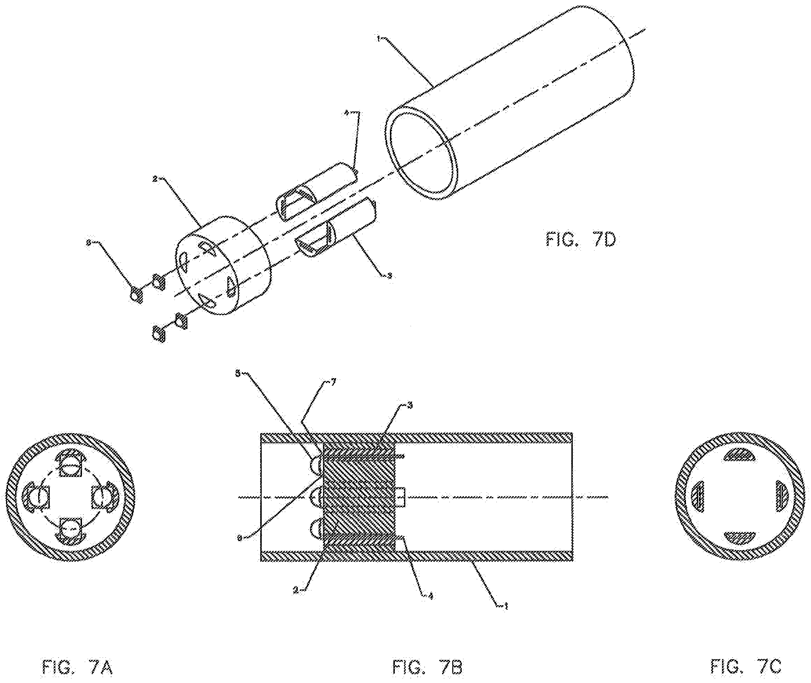

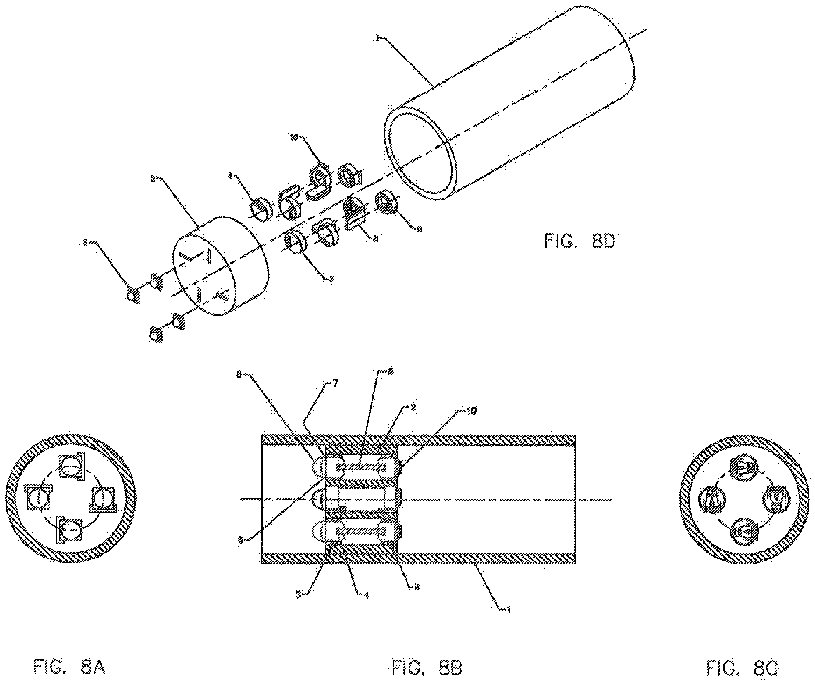

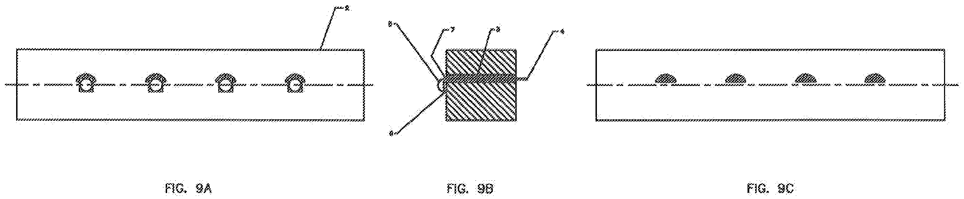

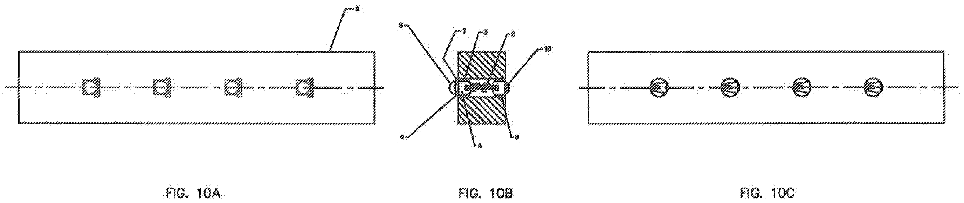

The present invention utilizes a thermally and electrically conductive metal outer member, a heatsink. The interior of the heatsink, or core, is an electrical insulating material that positions and electrically isolates a second electrically conductive member that extends out the end opposite from the LED to provide an electrical connection point. The top surface of this assembly provides a mounting surface for the LED. The anode or cathode side of the LED, and in some cases a dedicated thermal pad, is bonded to the top surface of the heatsink by soldering or some other thermally and electrically conductive method or material. The electrically opposite side of the LED package is bonded to the isolated second member. Power from an appropriate electrical circuit is applied to the heatsink and the isolated terminal to turn on the LED. Heat generated by the LED is conducted through the interface with the heatsink to ambient air. The LED runs much cooler and efficiently in this system than is possible with those mounted on printed circuit boards. Figures 1A through 11 depict variations on the design described above. As shown, the heatsink can be different shapes depending on the application. A heatsink can also support multiple LEDs in a variety of configurations; a circular array and a linear array are only two of many possibilities. Electronics with a suitable interconnect method can also be suspended in the insulating core. It is also possible in all cases to provide electrically insulating material that positions and electrically isolates two electrically conductive members that extend out the end opposite from the LED to provide electrical connection points. In these cases the cathode and anode LED pads are bonded to corresponding isolated pads and the LED thermal pad is bonded to the invention's heatsink surface.

The improved heatsink method depicted in Figures 1A through 11 does not utilize a PC board for mounting the LED; instead, the LED is mounted directly to the metal surface of the heatsink. This method produces much improved heat transfer and a cooler operating, higher lumens LED, compared to PC board mounted LED designs.

The present invention provides a direct efficient path to conduct heat away from an LED to ambient air outside of a flashlight or any other lighting device such as a headlamp, lantern or spotlight, as well as all types of area lighting that utilize high powered LEDs as a light source. Other heatsinking methods produce thermal paths that are interrupted by a large number of thermal junctions, some of which have poor thermal conductivity or high thermal resistance. Examples of prior art heatsinking methods are illustrated in Figures 12A through 13D. Unique to the present invention is the ability to solder the terminal and heatsink directly to the electrical and thermal pads of the LED. No thermal grease or adhesives are required. In other designs the equivalent heatsinking and electrical contact pads are on a PC board which results in more, less efficient, thermal junctions and longer, smaller cross section, thermal paths to ambient air. The use of thermal grease and adhesives in these less efficient designs helps heat transfer to some degree but not to the level of attaching the LED directly to the heatsink. The result of the much improved heat transfer possible with the invention is that the LED operates much cooler and therefore much more efficiently. Higher lumens are possible with no increase in power over conventional systems. It is also possible to maintain lumens at the same level as other less efficient systems but consume far less power. This is especially important in battery powered lighting systems as on-time is extended without reducing lumens. The superior performance of the present invention is demonstrated by the lumens output 60 seconds after applying a constant 4 amps of current to the LED. The invention was better than other systems as follows:
The present invention (Figs. 2A-D) produced 19 percent more lumens than the system in Figs. 13A-D (typical star, metal backed PC board mounted LED); and
The present invention (Figs. 2A-D) produced 93 percent more lumens than the system in Figs. 12A-D (multi-layer conventional PC board with extra copper traces and vias to attempt to conduct heat away from the LED).

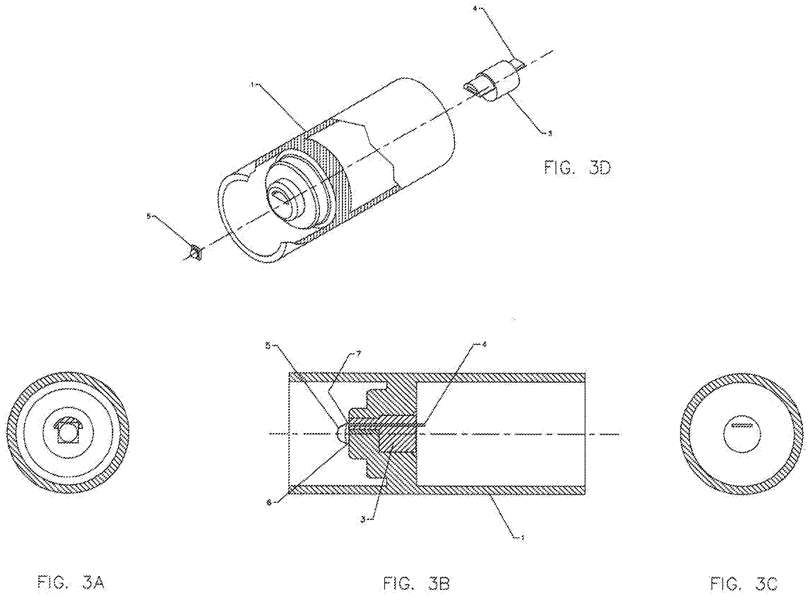

It is worth noting that the efficiency of the present invention can be increased or optimized, with the aid of the present disclosure, by increasing or maximizing the surface area exposure between the heatsink and the thermally and electrically conductive outer casing while also designing the heatsink to have a sufficient mass to effectively and efficiently conduct heat between the heatsink and the outer casing. Thus, for example, heatsink 2 in Figs. 2A-D will have better results than heatsink 2 of Figs. 1A-D, while Figs. 3A-D illustrate an embodiment in which the heatsink is integrally formed with the outer casing, which should result in better results than the heatsink of Figs. 2A-D.

It is also worth noting that the outer casing, which is illustrated in the exemplary embodiments depicted in Figs. 1-11 as a tube or barrel, need not be thermally and electrically conductive over its entire outer surface, although an outer casing which is thermally and electrically conductive over its entire outer surface may achieve better results.

It is further worth noting that the advantages obtained by the more efficient cooling of one or more LEDs obtained by the present invention can be used to create a flashlight mode use of increased lumens, or a flashlight mode with increased on-time, or one or more modes that alternate between such modes or combine elements of both such modes.

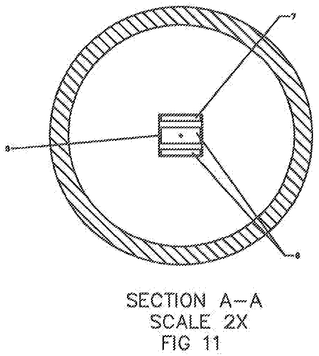

The present invention lends itself to a more efficient, less costly, lighting device that can be manufactured economically through automation. In illustrative embodiments shown in Figs. 19C-D and 20A-B, a heat sink assembly 200 is created by soldering two electrically conductive members of an LED 5 to a top surface of heatsink 2. Commercially available LEDs typically have three pads (see, e.g., Fig. 11D where second electrical connection 7 has one rectangular pad while thermal junction and first electrical connection between LED 5 and heatsink 2 have two rectangular pads) which can all be used for soldering (solder S1 in Fig. 19A is for one pad whereas solder S2 in Fig. 19A is for two pads). After heat sink assembly 200 is created, it can be press fit into a tube or barrel 1 as illustrated in Figs. 19C and 19D or it can be removably inserted into tube or barrel 1 and then held in place by a removable holding mechanism, an example of which is nut 1B illustrated in Fig. 20A and 20B. In the embodiments illustrated in Figs. 20A and 20B, in an especially preferred embodiment, tube or barrel 1 and heat sink 2 are made of aluminum, heat sink 2 is coated with a metallic plating (e.g., nickel) that helps promote the soldering process, and a skin cut is made of the aluminum where heat sink 2 comes into contact with a top surface 1AT of shoulder 1A formed in tube or barrel 1 (so as to promote more efficient thermal heat transfer).

## Claims

1. A lighting apparatus, comprising:
an outer casing (1)that is thermally and electrically conductive;
a light emitting diode ("LED") package contained within the outer casing (1), said LED package comprising:
a substrate;
an LED (5) on the substrate;
a first electrically conductive pad (6);
a second electrically conductive pad (7); and
a thermal pad configured for removing heat from the LED (5) to outside of the LED package;
wherein the first and second electrically conductive pads are configured to provide power to cause the LED to emit light;
wherein the first and second electrically conductive pads (6; 7) and the thermal pad are located on a rear surface of the substrate opposite from the front surface of the LED package; and
a thermally and electrically conductive heatsink assembly (200) held within and in thermal and electrical contact with the outer casing, said heatsink assembly (200) comprising:
an outer electrically conductive member that is thermally conductive and is held within and in thermal and electrical contact with the outer casing;
a core of an electrically insulating material which is held within a cavity formed in the outer electrically conductive member; and
a second electrically conductive member which is positioned and electrically isolated from the outer electrically conductive member by the core;
wherein the first electrically conductive pad (6) and the thermal pad are thermally and electrically bonded to a first top surface of the outer electrically conductive member without use of a printed circuit board and the second electrically conductive pad (7) is electrically bonded to the second electrically conductive member, wherein the lighting apparatus is comprised of a flashlight and the outer casing is comprised of a flashlight barrel (1).

2. The lighting apparatus of claim 1, wherein the first electrically conductive pad (6) and the thermal pad are soldered to the first top surface and the second electrically conductive pad (7) member is soldered to the second top surface.

## Patentansprüche

1. Beleuchtungsvorrichtung, umfassend:
ein äußeres Gehäuse (1), das thermisch und elektrisch leitfähig ist;
ein Leuchtdioden-("LED")-Paket, das in dem äußeren Gehäuse (1) enthalten ist, wobei das LED-Paket Folgendes umfasst:
ein Substrat;
eine LED (5) auf dem Substrat;
eine erste elektrisch leitfähige Kontaktstelle (6);
eine zweite elektrisch leitfähige Kontaktstelle (7); und
eine thermische Kontaktstelle, die eingerichtet ist, Wärme aus der LED (5) nach außerhalb des LED-Pakets zu entfernen;
wobei die erste und zweite elektrisch leitfähige Kontaktstelle konfiguriert sind, Energie bereitzustellen, um die LED dazu zu veranlassen, Licht zu emittieren;
wobei sich die erste und zweite elektrisch leitfähige Kontaktstelle (6; 7) und die thermische Kontaktstelle auf einer Rückfläche des Substrats gegenüber der Vorderfläche des LED-Pakets befinden; und
eine thermisch und elektrisch leitfähige Kühlkörperbaugruppe (200), die innerhalb des und in thermischem und elektrischem Kontakt mit dem äußeren Gehäuse gehalten wird, wobei die Kühlkörperbaugruppe (200) Folgendes umfasst:
ein äußeres elektrisch leitfähiges Element, das thermisch leitfähig ist und innerhalb des und in thermischem und elektrischem Kontakt mit dem äußeren Gehäuse gehalten wird;
einen Kern aus einem elektrisch isolierenden Material, der innerhalb eines Hohlraums, der in dem äußeren elektrisch leitfähigen Element gebildet ist, gehalten wird; und
ein zweites elektrisch leitfähiges Element, das mittels des Kerns positioniert und elektrisch von dem äußeren elektrisch leitfähigen Element isoliert wird;
wobei die erste elektrisch leitfähige Kontaktstelle (6) und die thermische Kontaktstelle thermisch und elektrisch mit einer ersten oberen Fläche des äußeren elektrisch leitfähigen Elements ohne die Verwendung einer Leiterplatte verbunden sind und die zweite elektrisch leitfähige Kontaktstelle (7) elektrisch mit dem zweiten elektrisch leitfähigen Element verbunden ist, wobei die Beleuchtungsvorrichtung eine Taschenlampe umfasst und das äußere Gehäuse einen Taschenlampenzylinder (1) umfasst.

2. Beleuchtungsvorrichtung nach Anspruch 1, wobei die erste elektrisch leitfähige Kontaktstelle (6) und die thermische Kontaktstelle an die erste obere Fläche gelötet sind und die zweite elektrisch leitfähige Kontaktstelle (7) an die zweite obere Fläche gelötet ist.

## Revendications

1. Appareil d'éclairage, comprenant :
un boîtier extérieur (1) qui est thermiquement et électriquement conducteur ;
un ensemble diode électroluminescente (« LED ») contenu dans le boîtier extérieur (1), ledit ensemble LED comprenant :
un substrat ;
une LED (5) sur le substrat ;
une première plaquette électriquement conductrice (6) ;
une deuxième plaquette électriquement conductrice (7) ; et
une plaquette thermique configurée pour éliminer de la chaleur de la LED (5) vers l'extérieur de l'ensemble LED ;
la première et la deuxième plaquette électriquement conductrice étant configurées pour fournir une puissance qui amène la LED à émettre de la lumière ;
la première et la deuxième plaquette électriquement conductrice (6 ; 7) et la plaquette thermique étant situées sur une surface arrière du substrat opposée à la surface avant de l'ensemble LED ; et
un ensemble dissipateur de chaleur thermiquement et électriquement conducteur (200) maintenu dans et en contact thermique et électrique avec le boîtier extérieur, ledit ensemble dissipateur de chaleur (200) comprenant :
un élément électriquement conducteur extérieur qui est thermiquement conducteur et est maintenu dans et en contact thermique et électrique avec le boîtier extérieur ;
un noyau en un matériau électriquement isolant qui est maintenu dans une cavité formée dans l'élément électriquement conducteur extérieur ; et
un deuxième élément électriquement conducteur qui est positionné et électriquement isolé de l'élément électriquement conducteur extérieur par le noyau ;
la première plaquette électriquement conductrice (6) et la plaquette thermique étant thermiquement et électriquement reliées à une première surface supérieure de l'élément électriquement conducteur extérieur sans utiliser une carte de circuit imprimé, et la deuxième plaquette électriquement conductrice (7) étant électriquement reliée au deuxième élément électriquement conducteur, l'appareil d'éclairage comprenant une lampe de poche et le boîtier extérieur comprenant un cylindre de lampe de poche (1).

2. Appareil d'éclairage selon la revendication 1, dans lequel la première plaquette électriquement conductrice (6) et la plaquette thermique sont soudées sur la première surface supérieure, et la deuxième plaquette électriquement conductrice (7) est soudée sur la deuxième surface supérieure.
